Europäisches Patentamt

European Patent Office

Office européen des brevets

(19)

(11) Numéro de publication : **0 432 004 B1**

(12) **FASCICULE DE BREVET EUROPEEN**

(45) Date de publication du fascicule du brevet :
09.09.92 Bulletin 92/37

(51) Int. Cl.⁵ : **G06F 11/20**

(21) Numéro de dépôt : **90403293.5**

(22) Date de dépôt : **21.11.90**

(54) **Circuit de redondance avec mémorisation de position de plot de sortie.**

(30) Priorité : **24.11.89 FR 8915508**

(43) Date de publication de la demande :
**12.06.91 Bulletin 91/24**

(45) Mention de la délivrance du brevet :
**09.09.92 Bulletin 92/37**

(84) Etats contractants désignés :
**DE FR GB IT**

(56) Documents cités :
**EP-A- 0 242 854**
**FR-A- 1 546 833**
**FR-A- 2 611 301**
**US-A- 3 868 646**

(56) Documents cités :
**IEEE TRANSACTIONS ON RELIABILITY, vol.
37, no. 3, août 1988, pages 331-339, IEEE, New
York, US; K.E. GROSSPIETSCH: "Schemesof
dynamic redundancy for fault tolerance in
Random Access Memories"**

(73) Titulaire : **SGS-THOMSON
MICROELECTRONICS S.A.
7, Avenue Galliéni
F-94250 Gentilly (FR)**

(72) Inventeur : **Costabello, Claude, Cabinet
Ballot-Schmit
7, rue Le Sueur
F-75116 Paris (FR)**

(74) Mandataire : **Schmit, Christian Norbert Marie
et al
Cabinet Ballot-Schmit 7, rue Le Sueur
F-75116 Paris (FR)**

## Description

L'invention concerne les mémoires réalisées en circuit intégré. Elle concerne aussi bien les mémoires vives (RAM), que les mémoires mortes (ROM, EPROM, EEPROM). Elle est cependant tout particulièrement intéressante dans le cas des mémoires "flash EPROM" qui sont programmables électriquement et effaçables électriquement par blocs.

L'invention concerne plus précisément les systèmes de redondance associés à ces mémoires.

Dans le brevet FR-A-8702372 on a décrit un système de redondance qui a pour but d'optimiser les possibilités de réparation de colonnes défectueuses à l'aide d'un nombre limité de colonnes de redondance, dans le cas où la mémoire est organisée en lignes et colonnes avec un nombre de colonnes multiple du nombre de plots de sortie de données de la mémoire. Autrement dit, la mémoire est destinée à fournir des mots de k bits (par exemple k=8) et il y a k fois p colonnes (par exemple p=64). La mémoire comprend k groupes de p colonnes et la sélection d'un mot dans la mémoire se fait par sélection simultanée d'une seule colonne dans chaque groupe. On se référera au texte de ce brevet pour plus de précision.

Le système de redondance de ce brevet repose sur l'idée qu'on va limiter le nombre de colonnes de redondance en mémorisant non seulement l'adresse d'une colonne défectueuse (1 parmi p) destinée à être remplacée par une colonne de redondance, mais aussi une position du plot correspondant à la colonne défectueuse.

La position du plot n'est pas nécessairement le rang 1 parmi k du plot. Dans ce brevet antérieur, c'est une position un peu fictive choisie de la manière suivante : on range les k plots en m ensembles de r plots, et à chaque ensemble est associé une colonne redondante ou un groupe de colonnes redondantes. La "position de plot" est une position 1 parmi r du plot à l'intérieur de l'ensemble auquel il appartient. Pour donner un exemple chiffré, s'il y a huit plots (k=8) arrangés en quatre ensembles (m=4) de deux plots (r=2), il y a deux positions de plot possibles dans chaque ensemble, qu'on pourrait appeler position 0 et position 1. Lorsqu'une colonne défectueuse est détectée et doit être remplacée par une colonne redondante, on effectue non seulement un remplacement de cette colonne défectueuse par une colonne redondante, mais aussi un remplacement simultané de toutes les colonnes (non défectueuses) correspondant à la même position de plot dans les autres ensembles et sélectionnées par la même adresse de colonne. Ainsi, dans l'exemple numérique donné ci-dessus, si une colonne défectueuse correspondant à une position de plot 1 est repérée, la mise en service de la redondance va consister à remplacer par une colonne redondante respective les quatre colonnes de position 1 qui sont sélectionnées par une adresse de colonne défectueuse. Mais on ne remplace pas les colonnes de même adresse et de position de plot 0.

Ce système de redondance repose donc sur la mise en mémoire permanente de plusieurs informations relatives aux colonnes défectueuses.

Tout d'abord on met en mémoire des adresses de colonnes défectueuses, dans une mémoire d'adresses de colonne défectueuse; chaque adresse permet de désigner une colonne défectueuse parmi p dans un groupe de p colonnes sans distinction entre les k groupes. Un comparateur surveille en permanence les adresses appliquées à la mémoire, en lecture comme en écriture; si une adresse de colonne défectueuse se présente, le comparateur réagit pour signaler que la redondance doit être mise en service; il signale aussi quel numéro de réparation doit être déclenché dans le cas général ou plusieurs possibilités de réparation sont prévues et repérées par des numéros.

Ensuite, pour chaque numéro de réparation, on mémorise la position de plot correspondant à la colonne effectivement défectueuse, sans distinction entre les ensembles. Cette information est enregistrée dans des éléments de mémorisation de position de plot. Lorsqu'une adresse défectueuse se présente à l'entrée de la mémoire, elle est repérée par le comparateur; celui-ci détermine quel est le numéro de réparation à mettre en service et fournit une information correspondante permettant de sélectionner les éléments de mémorisation de position de plot qui correspondent à ce numéro. Les éléments sélectionnés définissent une position de plot; tous les groupes de colonnes qui correspondent à cette position subiront un remplacement de colonne (défectueuse ou non) par une colonne redondante.

En pratique, dans le brevet antérieur FR-A-8702372 les éléments de mémorisation de position de plot sont des fusibles : s'il y a seulement deux positions de plot, un fusible seulement suffira à définir cette position. S'il y en a quatre il faudra deux fusibles, etc. Pour chaque numéro de réparation il faudra ces fusibles.

Lorsqu'il n'y a qu'une position de plot à définir parmi deux, la réalisation pratique est assez simple, il suffit de circuits logiques simples pour :
- recevoir du comparateur une information de numéro de réparation;
- sélectionner en fonction de cette information l'élément de mémorisation (le fusible) qui correspond à ce numéro,
- et examiner l'état du fusible correspondant pour établir une instruction de sélection des plots dont la position de plot est celle qu'indique le fusible.

Bien que cette situation soit assez simple, il faut cependant signaler qu'elle doit prendre en compte la nécessité d'inscrire l'information de position de plot.

Dans une solution avec fusible, on peut imaginer que les fusibles sont grillés par laser, auquel cas il n'y a pas besoin de circuiterie pour l'inscription. C'est la solution qui a été adoptée dans la demande de brevet 87/02372 déjà citée. Mais aujourd'hui, pour des raisons d'automatisation, on préfère effectuer une inscription électrique. Cela permet d'effectuer l'inscription immédiatement au moment où on détecte l'existence de colonnes défectueuses. Pour une inscription électrique, il faut de la circuiterie correspondante. Cela est vrai pour une mémorisation par un fusible, mais c'est vrai aussi si l'élément de mémorisation est un transistor à grille flottante qu'on utilise de plus en plus comme élément de mémorisation d'information permanente.

Là où la situation se complique beaucoup, c'est lorsque le nombre de positions de plots à mémoriser augmente ainsi que le nombre de possibilités de réparation. En effet, dans ce cas, il faut un décodage très vite complexe pour : d'une part sélectionner un groupe de fusibles parmi N s'il y a N numéros de réparation possibles; d'autre part désigner les positions de plot correspondant à l'état des différents fusibles ou transistors pour un numéro de réparation donné; et enfin inscrire l'état des éléments de mémorisation de position de plots, au moment du test de la mémoire.

Par exemple, s'il y a six réparations possibles et huit positions de plot, il faut six groupes de trois fusibles ou transistors, et un décodage complexe pour établir les connexions qui conviennent pour choisir un groupe parmi six et pour

    – sélectionner les colonnes de redondance de même position, cette position étant définie par l'état d'un groupe de trois fusibles,

    – inscrire électriquement l'état des fusibles à partir du résultat du test montrant qu'il y a une colonne défectueuse.

En pratique l'information de position de plot à inscrire électriquement doit venir de quelque part. On s'arrangera pour qu'elle vienne du plot sur lequel on a repéré un défaut. Cela suppose donc qu'on relie d'une manière ou d'une autre les éléments de mémorisation de position de plot aux plots correspondants en vue de l'inscription.

Toutes les connexions, décodeurs, et aiguillages nécessaires rendent ce principe de redondance avec mémorisation de position de plot assez difficile à mettre en oeuvre.

La difficulté n'existe d'ailleurs pas seulement dans un circuit où les k plots sont rangés en m ensembles de r plots avec une position de plot 1 parmi r définie simultanément pour tous les ensembles. Elle existe aussi dans le cas limite où m=1, c'est-à-dire dans le cas où la position de plot est une position 1 parmi k dans un ensemble unique de k plots.

L'invention propose de résoudre cette difficulté en augmentant le nombre d'éléments de mémorisation de position de plot par rapport à ce qui est strictement nécessaire, et en organisant ces éléments en forme de matrice de cellules de mémoire électriquement programmables (transistors à grille flottante).

L'accès de la matrice se fait en ligne par des conducteurs issus du comparateur (comparant les adresses de mémoire reçues aux adresses de colonne défectueuses), chaque conducteur correspondant à un numéro de réparation et à une ligne respective de la matrice; la sortie se fait en colonne vers des circuits de lecture/écriture associés à chaque colonne. Chaque circuit de lecture/écriture correspond à une position de plot et reçoit, pendant la phase d'inscription de position de plot, une information issue d'un plot correspondant à cette position.

Chaque colonne de la mémoire correspond à une position de plot respective; l'apparition d'un bit déterminé sur cette colonne correspond à la sélection d'une position de plot déterminée. C'est ainsi que sur N lignes on peut mémoriser N positions de plot différentes qui sont les positions correspondant à N colonnes défectueuses différentes.

Dans un exemple avec six possibilités de réparation et huit positions de plots, on aura 48 transistors à grille flottante organisés en matrice, alors que la réalisation normale impliquait seulement 18 transistors à grille flottante. Mais on gagne énormément sur la circuiterie de décodage correspondante, sans d'ailleurs compliquer la programmation : la programmation se fera ligne par ligne (six lignes), directement à partir d'une information issue d'un plot.

L'invention peut se définir de la manière suivante:

Une mémoire intégrée avec des entrées d'adresse de colonne et k plots d'entrée/sortie, comportant des circuits principaux avec des colonnes normales et des circuits de redondance, avec des colonnes de redondance

    – ces derniers comportant un bloc destiné à vérifier la nécessité d'une opération de réparation de colonne et cedit bloc comparant à cette fin les adresses de colonne reçues et les adresses de colonnes normales défectueuses mémorisées et fournissant une commande de sélection des circuits de redondance,

    – les circuits de redondance comportant également des éléments de mémorisation d'une position de plot d'entrée/sortie correspondant à une colonne normale défectueuse,

caractérisée en ce que

    – les éléments de mémorisation de position de plot sont des cellules de mémoire électriquement programmables en nombre égal au nombre N de réparations possibles multiplié par le nombre r de positions de plots d'entrée/sortie possibles, organisées en une mémoire auxiliaire de N lignes et r colonnes, chaque colonne de cette mémoire correspondant à une position de plot d'entrée/sortie déterminée,

    – les sorties de la mémoire auxiliaire commandant la transmission de l'information provenant d'une colonne normale ou d'une colonne redondante sur les plots d'entrée/sortie.

L'invention est tout particulièrement intéressante dans le cas des mémoires électriquement effaçables (EEPROM, flash EPROM) ou pas du tout effaçables (ROM, UPROM), par opposition aux mémoires effaçables par ultraviolet. En effet, pour ces dernières, qui comportent une fenêtre transparente aux ultraviolets, il faudrait prévoir un masquage spécial anti UV au dessus de la matrice de mémorisation de position de plot. Il est nécessaire en effet de ne pas effacer les informations de redondance. Ce masquage est encombrant car il comporte nécessairement des labyrinthes anti lumière. Cela réduit l'intérêt de l'invention.

D'autres caractéristiques et avantages de l'invention apparaîtront à la lecture de la description détaillée qui suit et qui est faite en référence au dessins annexés dans lesquels :

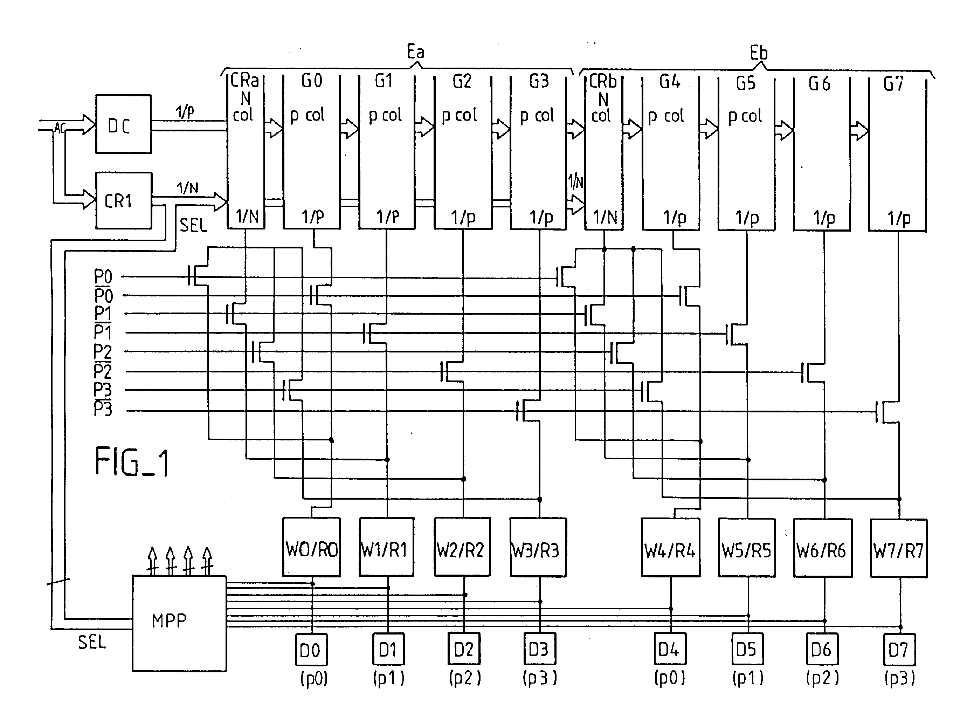

– la figure 1 représente un schéma global de réalisation de l'invention.

– la figure 2 représente plus précisément la constitution du bloc de mémorisation de positions de plot.

La réalisation qui va être décrite en détail pour mieux expliquer l'invention correspond à un exemple inspiré du brevet FR-A-8702372 (avec des modifications numériques). Il sera facile d'en déduire les modifications qui s'imposent pour d'autres exemples, et en particulier pour un exemple plus simple dans lequel par exemple les mots de huit bits sortent sur huit plots repérés chacun par une position parmi huit.

L'exemple décrit ci-après est construit à partir d'un exemple pratique simplifié dans lequel on a une mémoire de k=8 plots de sortie D0 à D7 pour extraire des mots de huit bits. La mémoire est organisée en huit groupes de colonnes, chaque groupe G0 à G7 comportant p colonnes (par exemple p=64) et correspondant à un plot respectif D0 à D7.

Les plots sont répartis en m=2 ensembles de r=4 plots, et dans chaque ensemble on définit une position de plot respective (1 parmi r) pour chaque plot. Les positions sont appelées p0, p1, p2, p3. Les plots D0 et D4 ont la position p0 chacun dans son ensemble, les plots D1 et D5 la position p1, etc.

Les groupes sont répartis en deux ensembles Ea et Eb exactement comme les plots, puisqu'à chaque groupe correspond un plot.

A chaque ensemble Ea et Eb est associé un groupe de colonnes de redondance respectif, CRa pour l'ensemble Ea, CRb pour l'ensemble Eb.

A partir de là on peut signaler que l'invention est applicable quel que soit le nombre m d'ensembles, y compris m=1, auquel cas la position de chaque plot est comprise entre 1 et k et il n'y a qu'un plot ayant une position déterminée.

La mémoire comporte un décodeur de colonne DC (présent indépendamment de la redondance) pour sélectionner, lorsqu'une adresse de colonne AC est appliquée à la mémoire, une colonne parmi p dans chacun des groupes simultanément, ce qui permet l'application d'un mot de huit bits sur les sorties D0 à D7.

Dans ce qui suit on parlera essentiellement de lecture même si la mémoire est inscriptible. Pour l'écriture, le mot de huit bits est appliqué aux plots D0 à D7 qui servent alors d'entrées de données et non de sorties de données.

L'adresse AC permet donc de sélectionner une colonne utile parmi p en sortie de chaque groupe.

Simultanément, cette adresse AC est appliquée à un circuit de redondance qui comporte d'abord un bloc CR1 destiné à vérifier la nécessité d'une opération de réparation de colonne et à sélectionner partiellement les colonnes de redondance servant à cette réparation.

Le bloc CR1 comprend d'une part des adresses de colonnes défectueuses mémorisées et d'autre part des moyens de comparaison entre les adresses reçues par la mémoire et les adresses mémorisées.

Si on suppose qu'il y a N possibilités de réparation simultanée de colonnes défectueuses, il y a N adresses AC en mémoire. L'adresse est l'adresse d'une colonne parmi p, c'est-à-dire qu'elle ne prend pas en compte le groupe dans lequel se situe la colonne défectueuse. S'il y a 64 colonnes, les adresses AC sont des adresses de 6 bits, et le circuit CR1 comporte N groupes de 6 éléments de mémorisation qui peuvent être des transistors à grille flottante (EPROM non effaçables ou UPROM) ou des fusibles.

Le bloc CR1 reçoit les adresses AC, les compare aux N adresses défectueuses mémorisées, et fournit sur un bus de N lignes (ou 2N si on compte les signaux et leurs compléments logiques) une commande de sélection d'une colonne de redondance parmi N dans chacun des ensembles Ea, Eb, c'est-à-dire dans chacun des groupes CRa, CRb.

Lorsqu'une adresse défectueuse est détectée, une colonne de redondance parmi N est sélectionnée en sortie de chaque groupe CRa, CRb, de même qu'une colonne normale est sélectionnée en sortie de chaque groupe G0 à G7.

En sortie des colonnes ainsi sélectionnées, que ce soient des colonnes normales ou des colonnes de redondance, il y a un multiplexeur destiné à choisir si l'information transmise aux plots doit émaner d'une colonne normale adressée par le décodeur AC ou d'une colonne de redondance adressée par le circuit CR1, et cela individuellement pour chacun des groupes de colonnes normales et pour chacun des groupes de colonnes de redondance.

Ce multiplexeur est commandé par des signaux p0, p1, p2, p3 (et leurs compléments logiques) qui correspondent aux positions de plots des colonnes défectueuses repérées au moment du test.

Le multiplexage est le suivant : si aucune position de plot n'est sélectionnée (aucune nécessité de réparation), p0 à P3 sont tous nuls; toute transmission des colonnes de redondance aux plots ou réciproquement est interdite. La transmission entre les colonnes normales sélectionnées et les plots correspondants sont autorisées.

Si une réparation est nécessaire et qu'elle correspond à la position de plot p0 (p0=1, p1, p2, p3 nuls), alors la transmission depuis les groupes de colonnes normales de position p0 (G0 et G4) vers les plots de position p0 (D0 et D4) est interdite et remplacée par une transmission vers ces mêmes plots respectivement de la colonne de redondance sélectionnée par CR1 dans chacun des groupes CRa et CRb. Pour les autres positions de plot, la transmission entre les colonnes normales et les plots reste autorisée et la transmission entre les colonnes de redondance et les plots reste interdite.

De même pour chacune des autres positions de plot, l'échange entre une colonne normale et une colonne de redondance ne se fait que pour la position de plot repérée par un signal logique non nul.

Les signaux p0 à p3 représentant les positions de plot sont issus du bloc MPP de mémorisation de position de plot qui comprend N groupes d'éléments de mémorisation sélectionnables par le bloc CR1.

Enfin, les colonnes normales ou de redondance sélectionnées par le multiplexeur sont reliées aux plots respectifs non pas directement mais par l'intermédiaire d'un circuit de lecture/écriture respectif associé à chaque plot. Les circuits de lecture/écriture sont désignés par W0/R0 pour le premier plot, W1/R1 pour le deuxième, etc.

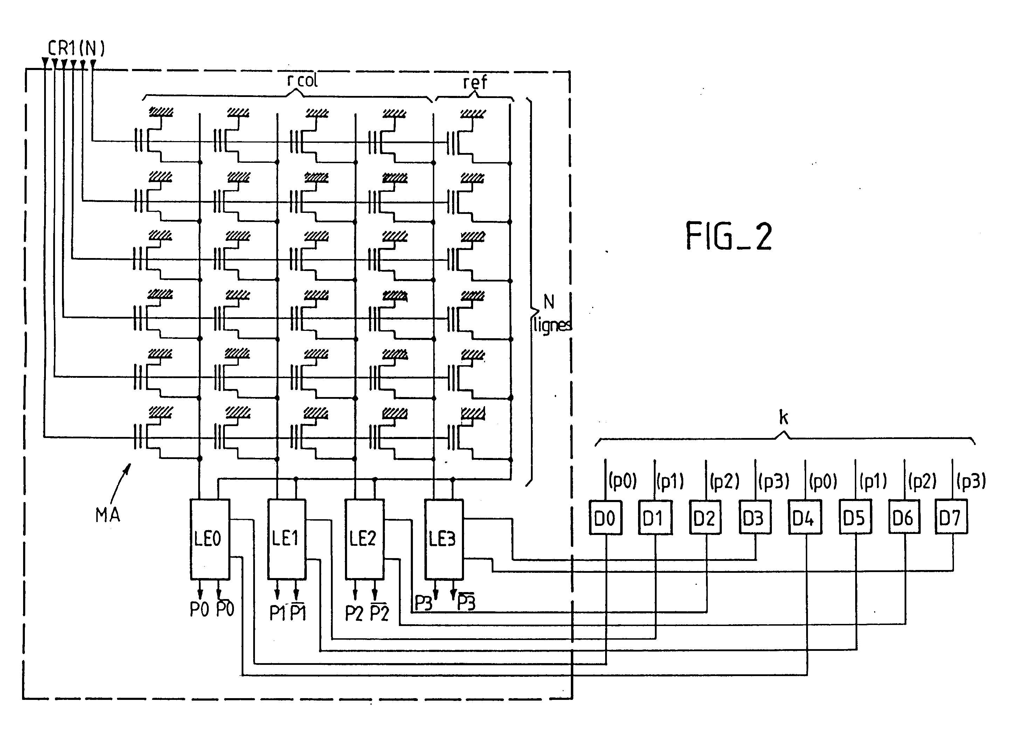

Le bloc MPP de mémorisation de position de plot est représenté en détail à la figure 2. Il est constitué sous forme d'une mémoire auxiliaire matricielle, avec des circuits de lecture et d'écriture des données stockées dans cette mémoire auxiliaire.

La mémoire auxiliare MA comporte N lignes de cellules de mémoire électriquement programmables et r colonnes, N étant, on le rappelle, le nombre de réparations possibles et r étant le nombre de positions de plot possibles dans chacun des m ensembles (m peut être égal à 1, auquel cas r est égal au nombre total k de plots). Chaque cellule est de préférence un transistor à grille flottante de type EPROM ou UPROM; ces cellules sont inscriptibles électriquement et non effaçables.

Le nombre total de cellules est largement supérieur à ce qui est strictement nécessaire, et cela d'autant plus que r est plus élevé. Pour r=4, le nombre de cellules est le double de ce qui est strictement nécessaire (4N au lieu de 2N); pour r=8, le rapport est encore supérieur (8N au lieu de 3N).

Mais grâce à cela on évite complètement des circuits de décodage encombrants.

L'adressage de cette mémoire MA du bloc MPP se fait par N conducteurs de ligne, chaque ligne de cellule comprenant un conducteur de ligne reliant les grilles de commande des transistors à grille flottante de cette ligne. Les N lignes de commande proviennent d'un bus de N conducteurs issu du bloc CR1. Ce bus est disponible en sortie du circuit CR1 puisque, comme on l'a expliqué, le circuit CR1 a pour fonction de sélectionner une colonne parmi N dans les groupes de colonnes de redondance.

Par conséquent, chaque fois que l'on sélectionne une colonne de redondance déterminée parmi N (correspondant à un numéro de réparation déterminé) on sélectionne en même temps une ligne de la mémoire du bloc MPP.

Sur les colonnes de la mémoire on lit alors un mot de r bits. Mais la programmation de la mémoire du bloc MPP est faite de telle sorte que les mots de r bits de cette mémoire ne comprennent en fait qu'un seul bit différent des autres (par exemple un bit 1 parmi r-1 bits zéro). Cela est possible du fait que la mémoire comporte r colonnes et qu'on cherche à stocker dans cette mémoire justement une position de plot parmi r.

Par conséquent, on va lire sur un conducteur de colonne de la mémoire MPP un bit 1, ce conducteur définissant alors la position de plot correspondant à une colonne défectueuse : à chaque conducteur de colonne de la mémoire correspond une position de plot déterminée unique et réciproquement.

La lecture de la mémoire (et d'ailleurs son écriture) se font d'une manière très classique pour des mémoires EPROM, à travers un circuit de lecture/écriture respectif pour chaque colonne. Les circuits de lecture/écriture sont désignés par LE0 à LE3 pour les colonnes représentant p0 à p3 respectivement.

On peut si on le désire, comme on fait couramment dans certaines mémoires EPROM, prévoir que les circuits de lecture/écriture fonctionnent par comparaison avec une colonne de référence comportant N transistors tous programmés de la même manière (c'est-à-dire tous programmés ou tous vierges), ces transistors étant commandés par les N conducteurs de ligne de la mémoire.

Les sorties des colonnes du bloc de mémoire de position de plot définissent les r signaux p0, p1, p2, p3 (avec leurs compléments logiques) qui sont nécessaires pour la commande du multiplexeur de la mémoire principale. Aucun décodage n'est nécessaire entre les sortie des la mémoire et les entrées de commande du multiplexeur.

Pour l'écriture des bits de cette mémoire (écriture d'un bit parmi r dans chaque ligne), on prévoit que le circuit de lecture/écriture LE0 est relié aux plot de position 0 (D0 et D4), le circuit LE1 est relié aux plots de position 1 (D1 et D5), etc. Ainsi, la programmation d'une position de plot se fait directement, sans décodage : au moment du test de la mémoire, on détecte une information erronée sur n'importe quel plot, par exemple D6. Un bit est alors placé sur ce plot pour être inscrit dans la mémoire du bloc MPP par l'intermédiaire du circuit de lecture/écriture LE2 qui est relié à ce bit. La position de plot p2 est ainsi mémorisée.

Dans le cas où le circuit de mémoire intégrée selon l'invention est une mémoire non effaçable par ultraviolets, par exemple lorsque c'est une mémoire flash EPROM effaçable électriquement par blocs, la mémoire de position de plot du bloc MPP peut être une mémoire EPROM; elle n'a pas besoin d'être protégée contre des ultraviolets auxquels elle serait exposée si la mémoire principale était une mémoire EPROM à fenêtre d'effacement UV. Par conséquent, la mémoire du bloc MPP n'a pas besoin d'être protégée par des masques d'aluminium et surtout par des labyrinthes de protection. Ces labyrinthes sont nécessaires pour éviter une pénétration latérale de lumière ultraviolette lors de l'effacement de la mémoire EPROM, car cette pénétration effacerait les données de redondance qui doivent être conservées. La mémoire MPP serait beaucoup plus volumineuse si elle devait être munie de ces labyrinthes de protection. L'absence de fenêtre UV pour les mémoires flash EPROM permet donc de minimiser la surface de la mémoire de positions de plot, ce qui est particulièrement avantageux.

L'invention s'applique tout particulièrement dans le cas où les positions de plot possibles sont au nombre de k, c'est-à-dire en nombre égal au nombre de plots. Pour des mémoires fournissant des mots de huit ou seize bits, on aurait donc huit ou seize positions de plot (r=8 ou r=16) et c'est pour ces mémoires que l'invention est la plus avantageuse car elle limite considérablement l'encombrement des circuits de décodage de position de plot qui étaient auparavant nécessaires.

## Revendications

1. Mémoire intégrée avec des entrées d'adresse de colonne (AC) et k plots d'entrée/sortie, comportant des circuits principaux (G0 à G7) avec des colonnes normales et des circuits de redondance (CRa, CRb), avec des colonnes de redondance
   – ces derniers comportant un bloc (CRI) destiné à vérifier la nécessité d'une opération de réparation de colonne et cedit bloc comparant à cette fin les adresses de colonne reçues et les adresses de colonnes normales défectueuses mémorisées et fournissant une commande de sélection des circuits de redondance,
   – les circuits de redondance comportant également des éléments (MPP) de mémorisation d'une position de plot d'entrée/sortie correspondant à une colonne normale défectueuse, caractérisée en ce que
   – les éléments de mémorisation de position de plot sont des cellules de mémoire électriquement programmables en nombre égal au nombre N de réparations possibles multiplié par le nombre r de positions de plots d'entrée/sortie possibles, organisées en une mémoire auxiliaire de N lignes et r colonnes, chaque colonne de cette mémoire correspondant à une position de plot d'entrée/sortie déterminée,
   – les sorties de la mémoire auxiliaire commandant la transmission de l'information provenant d'une colonne normale ou d'une colonne de redondance sur les plots d'entrée/sortie.

2. Mémoire intégrée selon la revendication 1, caractérisée en ce que l'information inscrite dans chaque ligne de la mémoire auxiliaire comprend un bit différent des r-1 autres bits de la même ligne, ce bit étant placé sur la colonne correspondant à une position de plot associée à une colonne défectueuse de la mémoire intégrée.

3. Mémoire selon l'une des revendications 1 et 2, caractérisée en ce que chaque colonne de la mémoire auxiliaire comprend un conducteur de colonne relié à un circuit de lecture/écriture, les sorties de lecture de ce circuit constituant les sorties de la mémoire auxiliaire, et les plots d'entrée-sortie d'une position donnée étant reliés à des entrées d'écriture du circuit de lecture/écriture de la colonne de mémoire auxiliaire correspondant à cette position de plot.

4. Mémoire selon l'une des revendications 1 à 3, caractérisée en ce qu'elle comporte k groupes de p colonnes de mémoire principale, chaque groupe correspondant à un plot, répartis en m ensembles (Ea, Eb) de r groupes, avec un groupe de colonnes de redondance (CRa, CRb) associé à chaque ensemble, et un multiplexeur directement commandé par les sorties de la mémoire auxiliaire pour définir si l'information transmise aux plots doit provenir d'une colonne normale ou d'une colonne de redondance de la mémoire principale.

5. Mémoire selon la revendication 4, caractérisée en ce que le multiplexeur établit les connexions suivantes à partir des conducteurs de colonne de la mémoire auxiliaire, ces conducteurs fournissant des signaux correspondant à des positions de plot (p0 à P3) :
   – si les signaux issus des colonnes sont tous nuls (aucune nécessité de réparation), toute transmission des colonnes de redondance aux plots de la mémoire ou réciproquement est interdite; les transmissions entre les colonnes de mémoire principale sélectionnées et les plots correspondants sont autorisées, et

– si une réparation est nécessaire et qu'elle correspond à une position de plot donnée, par exemple p0 (p0=1, p1, p2, p3 nuls), alors la transmission depuis les groupes de colonnes normales de position p0 (G0 et G4) vers les plots de position p0 (D0 et D4) est interdite et la transmission entre les colonnes de redondance et ces plots est autorisée; la transmission entre les autres plots et les colonnes normales est autorisée et la transmission entre les autres plots et les colonnes de redondance est interdite.

6. Mémoire selon l'une des revendications 1 à 5, caractérisée en ce qu'elle comporte un circuit de sélection de colonne de redondance, apte à sélectionner une colonne de redondance parmi N colonnes d'un groupe de colonnes de redondance, et en ce que les sorties de ce circuit commandent directement les lignes de la matrice de mémoire auxiliaire.

**Patentansprüche**

1. Integrierter Speicher mit Spaltenadreßeingängen (AC) und k Eingangs/Ausgangsanschlüssen, umfassend Hauptstromkreise (G0 bis G7) mit normalen Spalten und Redundanzstromkreise (CRa, CRb), mit Redundanzspalten,
   – wobei letztere einen Block (CR1) umfassen, der dazu bestimmt ist, die Notwendigkeit einer Operation zur Spaltenfehlerbehebung zu verifizieren, und wobei der Block zu diesem Zweck die empfangenen Spaltenadressen und die fehlerhaften gespeicherten normalen Spaltenadressen vergleicht und einen Befehl zur Auswahl der Redundanzstromkreise liefert,
   – wobei die Redundanzstromkreise in gleicher Weise Elemente (MPP) zur Speicherung einer Eingangs/Ausgangsanschlußposition umfassen, die einer fehlerhaften normalen Spalte entspricht,
   dadurch **gekennzeichnet**, daß
   – die Elemente zur Anschlußpositionsspeicherung elektrisch programmierbare Speicherzellen in der Zahl gleich der Zahl N von möglichen Fehlerbehebungen, multipliziert mit der Zahl r von möglichen Eingangs/Ausgangsanschlußpositionen sind, organisiert in einem Zusatzspeicher mit N Zeilen und r Spalten, wobei jede Spalte des Speichers einer bestimmten Eingangs/Ausgangsanschlußposition entspricht,
   – wobei die Ausgänge des Zusatzspeichers die Übertragung der Information steuern, die von einer normalen Spalte oder einer Redundanzspalte auf den Eingangs/Ausgangsanschlüssen herrühren.

2. Integrierter Speicher nach Anspruch 1, dadurch **gekennzeichnet**, daß die in jede Zeile des Zusatzspeichers geschriebene Information ein von den r-1 anderen Bits derselben Zeile verschiedenes Bit aufweist, wobei dieses Bit auf der Spalte entsprechend einer Anschlußposition angeordnet ist, die einer fehlerhaften Spalte des integrierten Speichers zugeordnet ist.

3. Speicher nach einem der Ansprüche 1 und 2, dadurch **gekennzeichnet**, daß jede Spalte des Zusatzspeichers einen mit einem Lese/Schreibkreis verbundenen Spaltenleiter aufweist, wobei die Leseausgänge dieses Kreises die Ausgänge des Zusatzspeichers bilden und die Eingangs/Ausgangsanschlüsse einer gegebenen Position mit Schreibeingängen des Lese/Schreibkreises der Zusatzspeicherspalte entsprechend dieser Anschlußposition verbunden sind.

4. Speicher nach einem der Ansprüche 1 bis 3, dadurch **gekennzeichnet**, daß er k Gruppen von p Hauptspeicherspalten umfaßt, wobei jede Gruppe einem Anschluß entspricht, verteilt in m Sätze (Ea, Eb) von r Gruppen, wobei eine Gruppe von Redundanzspalten (CRa, CRb) jedem Satz zugeordnet ist, und einen direkt durch die Ausgänge des Zusatzspeichers gesteuerten Multiplexer um zu definieren, ob die zu den Anschlüssen übermittelte Information von einer normalen Spalte oder einer Redundanzspalte des Hauptspeichers herrühren soll.

5. Speicher nach Anspruch 4, dadurch **gekennzeichnet**, daß der Multiplexer die folgenden Verbindungen ausgehend von Spaltenleitern des Zusatzspeichers bildet, wobei die Leiter Signale entsprechend Anschlußpositionen p0 bis p3 liefern:
   – wenn die ausgegebenen Signale der Spalten sämtlich Null sind (keine Notwendigkeit zur Fehlerbehebung), ist jegliche Übertragung der Redundanzspalten zu den Anschlüssen des Speichers oder umgekehrt gesperrt; die Übertragungen zwischen den ausgewählten Hauptspeicherspalten und den entsprechenden Anschlüssen sind gestattet, und
   – wenn eine Fehlerbehebung notwendig ist und sie einer gegebenen Anschlußposition entspricht, beispielsweise p0 (p0=1, p1, p2, p3 Nullen), dann ist die Übertragung von den Gruppen von normalen Spalten mit Position p0 (G0 und G4) zu den Positionsanschlüssen p0 (D0 und D4) gesperrt und die Übertragung zwischen den Redundanzspalten und den Anschlüssen ist gestattet; die Übertragung zwischen den anderen Anschlüssen und den normalen Spalten ist gestattet und die Übertragung zwischen den anderen Anschlüssen und den Redundanzspalten ist gesperrt.

6. Speicher nach einem der Ansprüche 1 bis 5, dadurch **gekennzeichnet**, daß er einen Kreis zur Redundanzspaltenauswahl umfaßt, der geeignet ist, eine Redundanzspalte aus N Spalten einer Gruppe von Redundanzspalten auszuwählen, und daß die Ausgänge dieses Kreises die Zeilen der Zusatzspeichermatrix direkt steuern.

## Claims

1. An integrated memory having column address (AG) inputs and k input/output terminals, comprising principal circuits (G0 to G7) having normal columns and redundancy circuits (GRa, GRb) having redundancy columns

   – the latter comprising a unit (GR1) adapted to verify the need for a column repair operation and the said unit comparing for this purpose the column addresses received and the addresses of defective normal columns stored in memory and supplying a command for selection of redundancy circuits,

   – the redundancy circuits also comprising elements (MPP) for storing the position of an input/output terminal corresponding to a defective normal column,

   characterized in that

   – the elements for storing the position of the terminal are electrically programmable memory cells present in a number equal to the number N of possible repairs multiplied by the number r of possible positions of input/output terminals, arranged in an auxiliary memory of N lines and r columns, each column of this memory corresponding to a defined input/output terminal position,

   – the outputs of the auxiliary memory control the transmission of the data coming from a normal column or a redundancy column on the input/output terminals.

2. An integrated armory according to claim 1, characterized in that the data written in each line of the auxiliary memory comprises a bit different from the r-1 other bits of the same line, this bit being positioned on the column corresponding to a terminal position connected to a defective column of the integrated memory.

3. A memory according to one of claims 1 or 2, characterized in that each column of the auxiliary memory comprises a column conductor connected to a read/write circuit, the read outputs of this circuit constituting the outputs of the auxiliary memory and the input/output terminals of a given position being connected to the write inputs of the read/write circuit of the auxiliary memory column corresponding to this terminal position.

4. A memory according to any one of claims 1 to 3, characterized in that it comprises k groups of p principal memory columns, each group corresponding to a terminal, distributed in m sets (Ea, Eb) of r groups, with one group of redundancy columns (CRa, CRb) associated with each set, and a multiplexer directly controlled by the outputs of the auxiliary memory for determining if the data transmitted to the terminals should be derived from a normal column or from a redundancy column of the principal memory.

5. A memory according to claim 4, characterized in that the multiplexer sets the following connections from column conductors of the auxiliary memory, these conductors supplying signals corresponding to positions of terminals (p0 to p3):

   – if the signals defined from the columns are all zero (no need for repair), all transmission from redundancy columns to terminals of the memory or conversely is inhibited; the transmissions between the columns of the principal memory selected and the corresponding terminals are enabled, and

   – if a repair is necessary and it corresponds to a given terminal position, for example p0 (p0 = 1, p1, p2, and p3 are zero), then transmission from the groups of normal columns of position p0 (G0 and G4) to the terminals having the position p0 (D0 and D4) is inhibited and transmission between the redundancy columns and these terminals is enabled; transmission between the other terminals and the normal columns is enabled and transmission between the other terminals and the redundancy columns is inhibited.

6. A memory according to any one of claims 1 to 5, characterized in that it comprises a circuit for selecting redundancy columns adapted to select one redundancy column from among N columns in a group of redundancy columns, and in that the outputs of the said circuit directly control the matrix lines of the auxiliary memory.

FIG_1

FIG_2

EP 0 432 004 B1